# EUROPEAN PATENT APPLICATION

(11) **EP 4 489 082 A1**
(43) Date of publication of application: **08.01.2025**
(21) Application number: 23869677.7
(22) Date of filing: 30.05.2023
(51) Int. Cl.: H01L 31/18, H01L 31/06, H01L 31/0236, H01L 31/0216

(54) **SOLAR CELL AND MANUFACTURING METHOD THEREFOR**

(30) Priority: 29.09.2022 CN 202211199636
(71) Applicant: Tongwei Solar (Chengdu) Co., Ltd., Chengdu, Sichuan 610299 (CN)
(72) Inventor: FAN, Jianbin, Chengdu, Sichuan 610299 (CN); MENG, Xiajie, Chengdu, Sichuan 610299 (CN)
(74) Representative: Michalski Hüttermann & Partner Patentanwälte mbB
(86) International application number: PCT/CN2023/097010
(87) International publication number: WO 2024/066424

(57) **Abstract**

Provided in the present application are a solar cell and a manufacturing method therefor. The manufacturing method for the solar cell comprises the following steps: providing a solar cell substrate, the solar cell substrate comprising a region A on which a first processing needs to be performed and a region B on which the first processing does not need to be performed; and forming on the region B a phosphorus-boron co-doped silicon oxide layer; and performing the first processing on the region A, the first processing comprising one or more of texturing processing, etching processing and wrapping-plating removal processing. In the manufacturing method for the solar cell, the phosphorus-boron co-doped silicon oxide layer serving as a mask layer is formed on the region B of the solar cell substrate on which the first processing does not need to be performed, and when the first processing is performed on the region A of the solar cell substrate, the phosphorus-boron co-doped silicon oxide layer can achieve a good blocking effect on the region B, so as to provide a long enough time window for the first processing procedure of the region A, thus helping to increase the yield of the solar cell.

## Description

This application claims priority to Chinese patent application No. 2022111996364, filed on September 29, 2022, entitled "SOLAR CELL AND MANUFACTURING METHOD THEREFOR", the content of which is hereby incorporated by reference in its entirety.

### TECHNICAL FIELD

The present application relates to the technical field of solar cells, and in particular to a solar cell and a method for preparing the same.

### BACKGROUND

In the preparation of crystalline silicon solar cells, such as a passivated emitter and rear cell (PERC), a tunnel oxide passivated contact (TOPCon) solar cell, and an interdigitated back contact (IBC) cell, complex cell structures are usually formed by multiple procedures to improve the conversion efficiency of the solar cell.

However, due to limitations of equipment and existing processes themselves, it is often difficult to obtain the required cell structures in one step. For example, in some cell designs, a front surface of a cell needs to be prepared as a textured surface, and a back surface is a polished structure. A conventional practice is to first polish both surfaces in a wet groove, next design a mask layer to serve as a barrier on the back surface of the cell, and then enter the wet groove, thereby achieving a textured front surface and a polished back surface. In some back contact cells, the back surface needs to be designed with grooves or patterns, and a mask structure is also needed. In addition, during the preparation of some solar cells, when a film layer is deposited on the back surface of a silicon wafer, a wrap-around layer is formed on the front surface of the silicon wafer, and it is also necessary to provide a mask layer on the back surface and then remove the wrap-around layer on the front surface.

A mask layer used in a conventional solar cell production process exhibits insufficient corrosion resistance, resulting in a short time window for processes such as texturing or wrap-around removal, and affecting the yield of cells.

### SUMMARY

Accordingly, it is necessary to provide a solar cell and a method for preparing the same, in which the solar cell has a mask layer with good corrosion resistance, can prolong the time window for processes such as texturing or wrap-around removal, and improve the yield of the cell.

According to a first aspect of the present application, a method for preparing a solar cell is provided. The method includes the following steps of:
providing a solar cell substrate, the solar cell substrate including an area A subjected to a first treatment and an area B not subjected to the first treatment;
forming a phosphorous-boron co-doped silicon oxide layer on the area B; and
performing the first treatment on the area A,
wherein the first treatment includes one or more selected from a texturing process, an etching process, and a wrap-around removal process.

In any embodiment, the solar cell substrate is a silicon wafer substrate, the area A includes a front surface of the silicon wafer substrate and a partial area of a back surface of the silicon wafer substrate, and the area B is an area of the back surface of the silicon wafer substrate that does not belong to the area A. The first treatment includes performing the texturing process on the area A of the front surface of the silicon wafer substrate with a chemical liquid for texturing, and performing an etching process on the area A of the back surface of the silicon wafer substrate.

In any embodiment, forming the phosphorous-boron co-doped silicon oxide layer on the area B includes the following steps of:
forming a phosphorous-boron co-doped silicon oxide layer on the back surface of the silicon wafer substrate;
patterning the back surface of the silicon wafer substrate to remove a part of the phosphorous-boron co-doped silicon oxide layer, wherein an area of the back surface of the silicon wafer substrate corresponding to a remaining phosphorus-boron co-doped silicon oxide layer is the area B.

In any embodiment, forming the phosphorous-boron co-doped silicon oxide layer on the back surface of the silicon wafer substrate includes the following steps of:
forming a phosphorus-doped amorphous silicon film layer and a boron-doped silicon oxide layer sequentially on the back surface of the silicon wafer substrate; and
annealing the silicon wafer substrate, such that the phosphorus-doped amorphous silicon film layer is converted into a phosphorus-doped polycrystalline silicon film layer, and the boron-doped silicon oxide layer absorbs phosphorus elements to form the phosphorus-boron co-doped silicon oxide layer.

In any embodiment, the phosphorus-doped amorphous silicon film layer and the boron-doped silicon oxide layer are sequentially formed on the back surface of the silicon wafer substrate through plasma enhanced chemical vapor deposition.

In any embodiment, forming the phosphorus-doped amorphous silicon film layer includes the following step of:
depositing the phosphorus-doped amorphous silicon film layer on the back surface of the silicon wafer substrate through plasma enhanced chemical vapor deposition by using a reaction gas containing phosphorane and silane, wherein during depositing the phosphorus-doped amorphous silicon film layer, a flow rate of the phosphorane in the reaction gas gradually increase.

In any embodiment, forming the boron-doped silicon oxide layer includes the following step of:
depositing the boron-doped silicon oxide layer on the back surface of the silicon wafer substrate by plasma enhanced chemical vapor deposition by using a reaction gas containing a boron source and silane, wherein during depositing the boron-doped silicon oxide layer, a flow rate of the boron source in the reaction gas is lower than 1/3 of a flow rate of the silane.

In any embodiment, an annealing temperature is 800°C to 950°C, and an annealing time is 15 min to 60 min.

In any embodiment, forming the phosphorous-boron co-doped silicon oxide layer on the back surface of the silicon wafer substrate includes the following steps of:
forming a phosphorus-doped silicon oxide layer on the back surface of the silicon wafer substrate through low-pressure chemical vapor deposition; and
performing boron diffusion on a surface of the phosphorus-doped silicon oxide layer to form the phosphorus-boron co-doped silicon oxide layer.

In any embodiment, the patterning includes the following step of:
treating the back surface of the silicon wafer substrate with a green laser or an ultraviolet laser to remove the part of the phosphorous-boron co-doped silicon oxide layer.

In any embodiment, prior to forming the phosphorus-doped amorphous silicon film layer on the back surface of the silicon wafer substrate, the method further includes the following step of:
forming an ultra-thin silicon oxide layer on the back surface of the silicon wafer substrate through plasma enhanced chemical vapor deposition, wherein the ultra-thin silicon oxide layer has a thickness from 1 nm to 3 nm.

In any embodiment, after performing the first treatment on the area A, the method further includes the following steps of:
removing the phosphorous-boron co-doped silicon oxide layer on the area B with a solution containing hydrogen fluoride; and
manufacturing a first electrode on the area A of the back surface of the silicon wafer substrate, and manufacturing a second electrode on the area B of the back surface of the silicon wafer substrate.

In any embodiment, after removing the phosphorous-boron co-doped silicon oxide layer on the area B and prior to manufacturing the first electrode and the second electrode, the method further includes the following step of:
depositing a first aluminum oxide film layer and a second aluminum oxide film layer on the front surface and the back surface of the silicon wafer substrate, respectively.

In any embodiment, after depositing the first aluminum oxide film layer and the second aluminum oxide film layer and prior to manufacturing the first electrode and the second electrode, the method further includes the following step of:
depositing a first anti-reflection film layer and a second anti-reflection film layer on the first aluminum oxide film layer and the second aluminum oxide film layer, respectively.

In any embodiment, the solar cell substrate is a silicon wafer substrate with a wrap-around layer on the front surface thereof; the area A includes the front surface of the silicon wafer substrate, and the area B includes a back surface of the silicon wafer substrate; and the first treatment is the wrap-around removal process on the area A.

In any embodiment, forming the phosphorous-boron co-doped silicon oxide layer on the area B includes the following steps of:
forming a phosphorus-doped amorphous silicon film layer and a boron-doped silicon oxide layer sequentially on the back surface of the silicon wafer substrate; and
annealing the silicon wafer substrate, such that the phosphorus-doped amorphous silicon film layer is converted into a phosphorus-doped polycrystalline silicon film layer, and the boron-doped silicon oxide layer absorbs phosphorus elements to form the phosphorus-boron co-doped silicon oxide layer.

In any embodiment, the phosphorus-doped amorphous silicon film layer and the boron-doped silicon oxide layer are sequentially formed on the back surface of the silicon wafer substrate through plasma enhanced chemical vapor deposition.

In any embodiment, forming the phosphorus-doped amorphous silicon film layer includes the following step of:
depositing the phosphorus-doped amorphous silicon film layer on the back surface of the silicon wafer substrate through plasma enhanced chemical vapor deposition by using a reaction gas containing phosphorane and silane, wherein during depositing the phosphorus-doped amorphous silicon film layer, a flow rate of the phosphorane in the reaction gas gradually increase.

In any embodiment, forming the boron-doped silicon oxide layer includes the following step of:
depositing the boron-doped silicon oxide layer on the back surface of the silicon wafer substrate by plasma enhanced chemical vapor deposition by using a reaction gas containing a boron source and silane, wherein during depositing the boron-doped silicon oxide layer, a flow rate of the boron source in the reaction gas is lower than 1/3 of a flow rate of the silane.

In any embodiment, an annealing temperature is 800°C to 950°C, and an annealing time is 15 min to 60 min.

In any embodiment, forming the phosphorous-boron co-doped silicon oxide layer on the area B includes the following steps of:
forming a phosphorus-doped silicon oxide layer on the back surface of the silicon wafer substrate through low-pressure chemical vapor deposition; and
performing boron diffusion on a surface of the phosphorus-doped silicon oxide layer to form the phosphorus-boron co-doped silicon oxide layer.

According to a second aspect of the present application, a solar cell is provided. The solar cell is prepared by the method for preparing a solar cell in the first aspect of the present application.

In any embodiment, the solar cell includes a silicon wafer substrate, an ultra-thin silicon oxide layer, a phosphorus-doped polycrystalline silicon film layer, a first electrode, and a second electrode;
the silicon wafer substrate has an n-type doped area and a p-type area on a back surface thereof, the ultra-thin silicon oxide layer and the phosphorus-doped polycrystalline silicon film layer are successively disposed within the n-type doped area of the back surface of the silicon wafer substrate, the first electrode is disposed within the p-type area and is in contact with the silicon wafer substrate; and the second electrode is disposed within the n-type doped area and is in contact with the phosphorus-doped polycrystalline silicon film layer.

In any embodiment, the solar cell further includes a first aluminum oxide film layer, a first anti-reflection film layer, a second aluminum oxide film layer, and a second anti-reflection film layer;
the first aluminum oxide film layer and the first anti-reflection film layer are sequentially stacked on the front surface of the silicon wafer substrate; the second aluminum oxide film layer is disposed on a surface of the phosphorus-doped polycrystalline silicon film layer within the n-type doped area away from the ultra-thin silicon oxide layer and a surface of the silicon wafer substrate within the p-type area; the second anti-reflection film layer is disposed on a surface of the second aluminum oxide film layer away from the silicon wafer substrate; the first electrode extends through the second anti-reflection film layer and the second aluminum oxide film layer and is in contact with the silicon wafer substrate; and the second electrode extends through the second anti-reflection film layer and the second aluminum oxide film layer and is in contact with the phosphorus-doped polycrystalline silicon film layer.

The phosphorus-boron co-doped silicon oxide layer is formed on region B of the solar cell substrate not subjected to the first treatment as a mask layer. Since the phosphorous-boron co-doped silicon oxide layer has an ultra-strong corrosion resistance, it can exert a good blocking effect on the region B when performing the first treatment on the region A of the solar cell substrate, thereby providing a sufficiently long time window for the first treatment, e.g., texturing, etching, wrap-around removal, etc. on the region A, and improving the yield of solar cells.

### BRIEF DESCRIPTION OF THE DRAWINGS

In order to better describe and illustrate embodiments and/or examples of the present application, reference may be made to one or more of the drawings. The additional details or examples used to describe the drawings should not be considered limiting of the scope of any one of the disclosed applications, the presently described embodiments and/or examples, and the best mode presently understood of these applications.
FIG. 1 is a schematic view of a silicon wafer substrate used in an embodiment of the present application.
FIG. 2 is a schematic view of a silicon wafer substrate on which a phosphorus-boron co-doped silicon oxide layer is formed according to an embodiment of the present application.
FIG. 3 is a schematic view of the silicon wafer substrate after patterning a back surface according to an embodiment of the present application.
FIG. 4 is a schematic view of the silicon wafer substrate after texturing a front surface and etching a patterned area according to an embodiment of the present application.
FIG. 5 is a schematic view after forming patterned openings in the patterned area according to an embodiment of the present application.
FIG. 6 is a schematic structural view of a solar cell prepared according to an embodiment of the present application.
FIG. 7 is a schematic view of the back surface of the solar cell prepared according to an embodiment of the present application.

Description of reference signs:
1. silicon wafer substrate; 2-1. ultra-thin silicon oxide layer; 2-2. phosphorus-doped polycrystalline silicon film layer; 4. phosphorus-boron co-doped silicon oxide layer; 5. patterned area; 6. first aluminum oxide film layer; 7. second aluminum oxide film layer; 8. first anti-reflection film layer; 9. second anti-reflection film layer; 10. electrode contact area; 11. first electrode; 12. second electrode; 100. back contact solar cell.

### DETAILED DESCRIPTION

In order to make the above objects, features and advantages of the present application more comprehensible, specific embodiments of the present application are described in detail below. In the following description, many specific details are set forth to make the present application fully understandable. However, the present application can be implemented in many other ways different from those described herein. Similar improvements can be made by those skilled in the art without departing from the spirit of the present application. The present application is not limited to the specific embodiments disclosed below.

In addition, the terms "first" and "second" are only used for descriptive purposes and cannot be understood as indicating or implying relative importance or implicitly indicating the quantity of the indicated technical features. Therefore, the features modified by "first" or "second" may explicitly or implicitly include at least one of the features. In the description of the present application, the "plurality" means at least two, such as two, three, etc., unless otherwise specifically defined.

In the present application, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element, or connected to the other element via an intermediate medium, or may be internal communication between two elements or interaction between two elements. For those skilled in the art, the specific meanings of the above terms in the present application can be understood according to specific circumstances.

Unless otherwise defined, all technical and scientific terms used herein have the same meaning as commonly understood by those of ordinary skill in the art to which the present application pertains. The terms used in the specification of the present application herein are for the purpose of describing embodiments only and are not intended to limit the present application. As used herein, the term "and/or" includes any or all combinations of one or more relevant listed items.

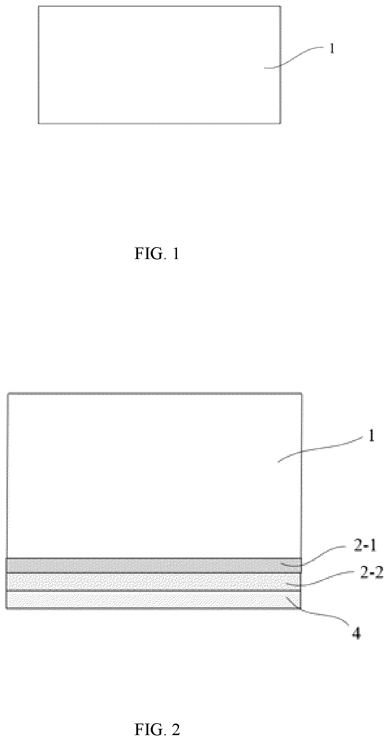

Referring to FIGs. 1 to 5, an embodiment of the present application provides a method for preparing a back contact solar cell 100. The method includes the following steps S1 to S9.

Step S1: a silicon wafer substrate 1 (i.e., a solar cell substrate) is subjected to a damage removal treatment, a polishing treatment, and a washing treatment sequentially. The structure of the silicon wafer substrate 1 is shown in FIG. 1.

In one specific example, the silicon wafer substrate 1 is treated with a solution containing KOH at 60°C for damage removal. Next, the silicon wafer substrate 1 is polished with a solution containing KOH at 75°C to obtain a polished silicon wafer substrate 1 with 30% of reflectivity. Subsequently, the silicon wafer substrate 1 is washed with a mixed solution containing hydrofluoric acid and hydrochloric acid, and deionized water, and then dried.

In this embodiment, the silicon wafer substrate 1 is specifically a p-type silicon substrate. In some other embodiments, the silicon wafer substrate 1 can also be an n-type silicon substrate.

Step S2: an ultra-thin silicon oxide layer 2-1, a phosphorus-doped amorphous silicon film layer, and a boron-doped silicon oxide layer are successively deposited on a back surface of the silicon wafer substrate 1 through plasma enhanced chemical vapor deposition (PECVD).

In some embodiments, during deposition of the phosphorus-doped amorphous silicon film layer, phosphorane and silane are used as reaction gases, and a flow rate of the phosphorane is lower than a flow rate of the silane. Furthermore, a low flow rate of phosphorane and a high flow rate of silane are introduced at an initial stage of depositing the phosphorus-doped amorphous silicon film layer. After the phosphorus-doped amorphous silicon film layer is deposited to 10 nm to 30 nm, the flow rate of the phosphorane is increased, while the flow rate of the silane remains unchanged during the deposition. Thus, a small recombination can be formed near the surface of the silicon wafer substrate 1, and a large phosphorus concentration is formed on a side of the phosphorus-doped amorphous silicon film layer away from the silicon wafer substrate 1, which can enhance the field passivation and facilitate the generation of a boron-phosphorus co-doped layer.

In some embodiments, when the boron-doped silicon oxide layer is deposited, a boron source and silane are used as reaction gases, and a flow rate of the boron source is controlled to be less than 1/3 of a flow rate of the silane. Boron phosphorus glass can be formed with phosphorus by boron doping, which provides a relatively strong corrosion resistance. During deposing the boron-doped silicon oxide layer, the content of boron needs to be controlled at a relatively low level, so that boron elements do not significantly enter a silicon body to cause carrier recombination.

In some embodiments, a thickness of the ultra-thin silicon oxide layer 2-1 is 0.5 nm to 3 nm, preferably 2 nm. A thickness of the phosphorus-doped amorphous silicon film layer is 30 nm to 300 nm, preferably 100 nm to 150 nm. A thickness of the boron-doped silicon oxide layer is 10 nm to 100 nm, preferably 20 nm to 50 nm. The temperature for depositing to form the above ultra-thin silicon oxide layer 2-1, the phosphorus-doped amorphous silicon film and the boron-doped silicon oxide layer is 200°C to 500°C, preferably 450°C.

Step S3: the silicon wafer substrate 1 is subjected to an annealing treatment. The silicon wafer substrate 1 after annealing is shown in FIG. 2.

By annealing the silicon wafer substrate 1, amorphous silicon (i.e., a-Si) deposited by PECVD can be converted into polycrystalline silicon (i.e., Poly-Si) and crystalline grains grow to become larger. Meanwhile, the loose boron-doped silicon oxide layer formed by PECVD can be densified, thereby enhancing the alkali resistance thereof.

In the annealing process, the deposited boron-doped silicon oxide layer absorbs a part of phosphorus elements from the phosphorus-doped polycrystalline silicon film layer 2-2 which is converted from the phosphorus-doped amorphous silicon film layer, and forms a phosphorus-boron co-doped silicon oxide layer 4 with boron atoms, thereby greatly enhancing the corrosion resistance of silicon oxide.

In some embodiments, an annealing temperature is 800°C to 950°C, preferably 850°C to 920°C; and an annealing time is 15 min to 60 min, preferably 45 min.

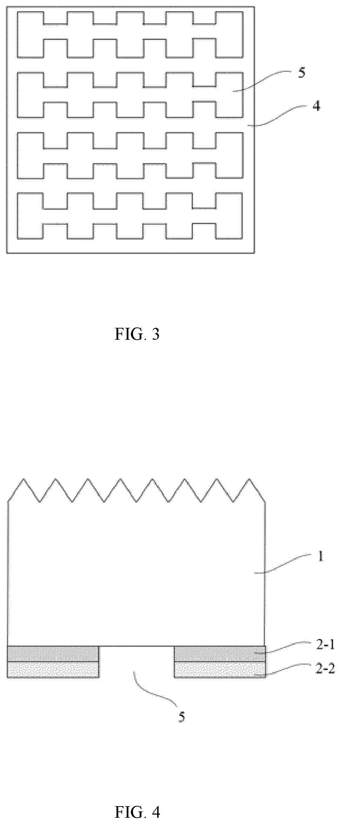

Step S4: the back surface of the silicon wafer substrate 1 is patterned to remove a part of the phosphorous-boron co-doped silicon oxide layer 4, thus forming a patterned area 5 not including the phosphorous-boron co-doped silicon oxide layer 4. The structure of the back surface of the patterned silicon wafer substrate 1 is shown in FIG. 3.

In some embodiments, the back surface of the silicon wafer substrate 1 is patterned using a green laser or an ultraviolet laser to remove the phosphorus-boron co-doped silicon oxide layer 4 in a partial area of the back surface of the silicon wafer substrate 1, thereby forming the patterned area 5, such that the p-type area and the n-type area of the solar cell are locally and spatially isolated with each other. The patterned area 5 has a width ranging from 300 µm to 500 µm.

The patterned area 5 and the front surface of the silicon wafer substrate 1 are referred to as an area A, which needs to be subjected to a texturing and etching process. After the patterning, an area of the back surface of the silicon wafer substrate 1 where the phosphorus-boron co-doped silicon oxide layer 4 is provided is an area B. The area B is a surface protected with the phosphorus-boron co-doped silicon oxide layer 4 as a mask, which does not need to be subjected to the texturing and etching process.

Step S5: the texturing process is performed on the front surface of the silicon wafer substrate 1, and the etching process is performed on the patterned area 5 on the back surface of the silicon wafer substrate 1. The textured and etched silicon wafer substrate 1 is shown in FIG. 4.

In some embodiments, the silicon wafer substrate 1 is treated with a solution containing KOH or NaOH in combination with a texturing additive at a temperature ranged from 70°C to 85°C, so as to texture the front surface of the silicon wafer substrate 1 to form a textured structure, and also to etch the patterned area 5 on the back surface of the silicon wafer substrate 1, for removing the polycrystalline silicon remained in the patterned area 5 and exposing the back surface of the silicon wafer substrate 1 within the patterned area 5. During the texturing and etching process, since the area B of the silicon wafer substrate 1 is protected with the phosphorus-boron co-doped silicon oxide layer 4, the polycrystalline silicon layer thereon will not be corroded and destroyed by the solution for texturing.

After the texturing and etching process is completed, the phosphorus-boron co-doped silicon oxide layer 4 covered on the area B can be removed with a solution containing hydrogen fluoride, after which, the silicon wafer substrate 1 is washed.

Step S6: a first aluminum oxide film layer 6 and a second aluminum oxide film layer 7 are deposited on the front surface and the back surface of the silicon wafer substrate 1, respectively.

In some embodiments, an atomic layer deposition (ALD) device is used to perform film plating simultaneously on both the front surface and the back surface of the silicon wafer substrate 1 in a single insertion manner, such that a first aluminum oxide film layer 6 is formed on the front surface of the silicon wafer substrate 1, and a second aluminum oxide film layer 7 is formed on the back surface of the silicon wafer substrate 1. The first aluminum oxide film layer 6 and the second aluminum oxide film layer 7 both serve the function of passivation. The thickness of the first aluminum oxide film layer 6 is 2 nm to 25 nm, and the thickness of the second aluminum oxide film layer 7 is 2 nm to 25 µm.

Step S7: a first anti-reflection film layer 8 and a second anti-reflection film layer 9 are deposited on the first aluminum oxide film layer 6 and the second aluminum oxide film layer 7, respectively.

In some embodiments, the first anti-reflection film layer 8 is deposited on the first aluminum oxide film layer 6 on the front surface of the silicon wafer substrate 1 by PECVD, and the second anti-reflection film layer 9 is deposited on the second aluminum oxide film layer 7 on the back surface of the silicon wafer substrate 1 by PECVD. The first anti-reflection film layer 8 and the second anti-reflection film layer 9 are each independently any one or a combination thereof selected from silicon nitride, silicon oxynitride, and silicon oxide. The first anti-reflection film layer 8 has a thickness from 60 nm to 150 nm, and the second anti-reflection film layer 9 has a thickness from 50 nm to 150 nm.

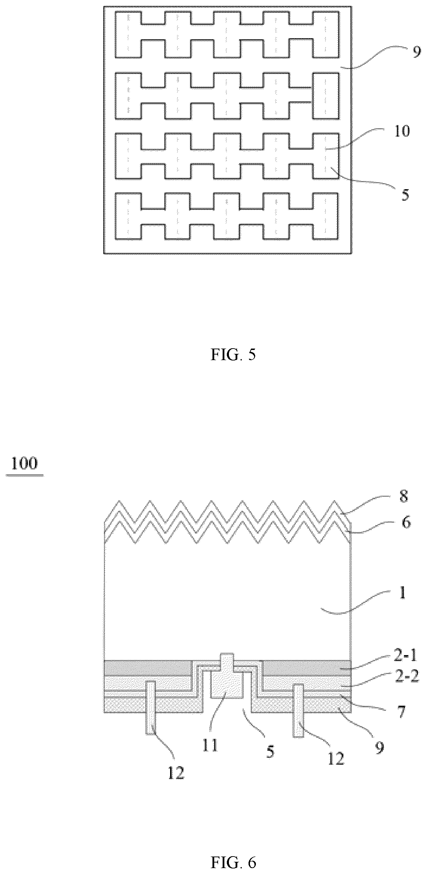

Step S8: patterned openings are formed in the patterned area 5 of the back surface of the silicon wafer substrate 1 with a laser to form an electrode contact area 10. The back surface of the silicon wafer substrate 1 with the patterned openings is shown in FIG. 5.

Specifically, the patterned openings are formed in the patterned area 5 by using a laser according to a predetermined pattern, and the second aluminum oxide film layer 7 and the second anti-reflection film layer 9 within the opening area are removed, thereby forming the electrode contact area 10 of the p-type area.

In some embodiments, the opening area can be in a shape of a dotted line or a dot, and a width of the opening is 30 µm to 50 µm.

Step S9: a first electrode 11 is manufactured in the electrode contact area 10, and a second electrode 12 is manufactured in an area of the back surface of the silicon wafer substrate 1 other than the patterned area 5.

In some embodiments, an electrode paste layer containing a conductive component is printed within the electrode contact area 10 by means of screen printing to form the first electrode 11. The first electrode 11 is in contact with the silicon wafer substrate 1.

A burn-through-type electrode slurry layer containing a conductive component is printed within an area (i.e., an area with a phosphorus-doped polycrystalline silicon layer) of the back surface of the silicon wafer substrate 1 other than the patterned area 5 by means of screen printing to form the second electrode 12. The second electrode 12 can be in contact with the phosphorus-doped polycrystalline silicon layer due to the burn-through effect of the electrode slurry.

In some embodiments, a width of the first electrode 11 is 50 µm to 200 µm; and a width of the second electrode 12 is 10 µm to 50 µm.

According to the method for preparing a solar cell in the present application, the phosphorus-doped amorphous silicon film layer and the boron-doped silicon oxide layer are deposited on the back surface of the silicon wafer substrate 1, and then the silicon wafer substrate 1 is annealed such that a portion of phosphorus elements in the phosphorus-doped polycrystalline silicon film layer 2-2 are absorbed by the boron-doped silicon oxide layer, and the phosphorus-boron co-doped silicon oxide layer 4 is formed with boron atoms, thereby greatly enhancing the corrosion resistance of silicon oxide. The phosphorus-boron co-doped silicon oxide layer 4 is used as a mask layer, which can greatly prolong the time window for processing the subsequent texturing/etching step and can improve the yield of cells.

An embodiment of the present application provides another method for preparing a back contact solar cell 100. This preparation method is basically the same as the preparation method in the embodiments described above, except that the specific methods for forming the phosphorus-boron co-doped silicon oxide layer 4 are different.

In this embodiment, the phosphorus-doped amorphous silicon film layer is first formed on the back surface of the silicon wafer substrate 1, the phosphorus-doped silicon oxide layer is formed on the surface of the phosphorus-doped amorphous silicon film layer away from the silicon wafer substrate 1 through low-pressure chemical vapor deposition (LPCVD), and boron diffusion is performed on the surface of the phosphorus-doped silicon oxide layer to form the phosphorus-boron co-doped silicon oxide layer 4. The phosphorus-boron co-doped silicon oxide layer 4 formed in this embodiment also has good corrosion resistance, which can also prolong the time window for the treatment process and can improve the yield of cells.

It can be understood that, the method for preparing the phosphorus-boron co-doped silicon oxide layer 4 is not limited to the above two methods. In addition to the above two methods, any method capable of preparing the phosphorus-boron co-doped silicon oxide layer 4 with good corrosion resistance can be used.

An embodiment of the present application provides a method of removing a wrap-around layer on a solar cell substrate.

In some embodiments, the solar cell substrate is a silicon substrate 1 with a wrap-around layer on the front surface. The area A of the solar cell substrate is the front surface of the solar cell substrate. The area B of the solar cell substrate is the back surface of the solar cell substrate. When removing the wrap-around layer on the front surface of the solar cell substrate, a phosphorus-boron co-doped silicon oxide layer 4 is first formed on the area B of the solar cell substrate to serve as a mask layer, and then a wrap-around removal process is performed on the solar cell by using an acid or alkali solution, so as to remove the wrap-around layer on the front surface of the solar cell substrate. During the wrap-around removal process, the phosphorus-boron co-doped silicon oxide layer 4 on the area B can serve as a barrier and provide a prolonged time window for the wrap-around removal process, thereby improving the yield of cells.

In some embodiments, the solar cell substrate is the silicon wafer substrate 1. A plated layer is deposited on the back surface of the silicon wafer substrate 1, and the plated layer is wrapped around to the front surface of the silicon wafer substrate 1.

The structure of the back contact solar cell 100 prepared in the present application will be described below with reference to the drawings.

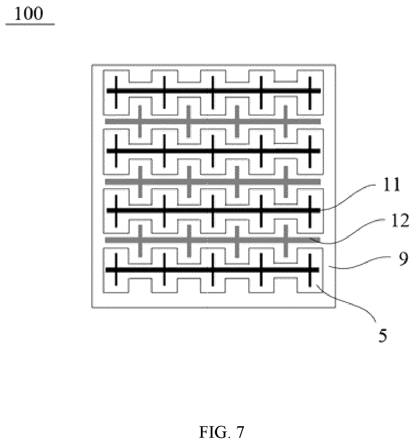

As shown in Figs. 6 and 7, the back-contact solar cell 100 includes a p-type silicon wafer substrate 1. A first aluminum oxide film layer 6 is disposed on the front surface of the silicon wafer substrate 1 (i.e., an upper surface of the silicon wafer substrate 1 in the figure). A first anti-reflection film layer 8 is disposed on the first aluminum oxide film layer 6. The first aluminum oxide film layer 6 has a thickness ranged from 2 nm to 25 nm. The first anti-reflection film layer 8 has a thickness ranged from 60 nm to 150 nm. The first anti-reflection film layer 8 is any one or a combination thereof selected from silicon nitride, silicon oxynitride and silicon oxide.

The back surface (i.e., a lower surface of the silicon wafer substrate 1 in the figure) of the silicon wafer substrate 1 is provided with an n-type doped area, which consists of an ultra-thin silicon oxide layer 2-1 and a phosphorus-doped polycrystalline silicon film layer 2-2 are successively disposed. The area of the back surface of the silicon wafer substrate 1 other than the n-type doped area forms the p-type area, in which no ultra-thin silicon oxide layer 2-1 and phosphorus-doped polycrystalline silicon film layer 2-2 is provided, and the n-type doped area and the p-type area are arranged alternately. The thickness of the ultra-thin silicon oxide layer 2-1 is 0.5 nm to 3 nm. The thickness of the phosphorus-doped polycrystalline silicon film layer 2-2 is 30 nm to 300 nm. The width of the n-type doped area is 600 µm to 1200 µm. The width of the p-type area is 300 µm to 500 µm.

A second aluminum oxide film layer 7 is further provided on the n-type doped area and the p-type area of the back surface of the silicon wafer substrate 1. A second anti-reflection film layer 9 is provided on the second aluminum oxide film layer 7. The second aluminum oxide film layer 7 has a thickness from 2 µm to 25 µm. The second anti-reflection film layer 9 has a thickness from 50 nm to 150 nm. The second anti-reflection film layer 9 is any one or a combination thereof selected from silicon nitride, silicon oxynitride and silicon oxide.

A first electrode 11 is provided within the p-type area. The first electrode 11 extends through the second aluminum oxide film layer 7 and the second anti-reflection film layer 9 and is in contact with the silicon wafer substrate 1. A second electrode 12 is provided within a range corresponding to the n-type doped area of the back surface of the silicon wafer substrate 1. The second electrode 12 extends through the second aluminum oxide film layer 7 and the second anti-reflection film layer 9 and is in contact with the phosphorus-doped polycrystalline silicon film layer 2-2. The first electrode 11 is an aluminum gate electrode. The width of the first electrode 11 is 50 µm to 200 µm. The second electrode 12 is a silver gate electrode. The width of the second electrode 12 is 10 µm to 50 µm.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims, and the specification and drawings may be used to explain the contents of the claims.

## Claims

1. A method for preparing a solar cell, comprising the following steps of:
providing a solar cell substrate, the solar cell substrate comprising an area A subjected to a first treatment and an area B not subjected to the first treatment;
forming a phosphorous-boron co-doped silicon oxide layer on the area B; and
performing the first treatment on the area A,
wherein the first treatment comprises one or more selected from a texturing process, an etching process, and a wrap-around removal process.

2. The method for preparing the solar cell according to claim 1, wherein the solar cell substrate is a silicon wafer substrate, the area A comprises a front surface of the silicon wafer substrate and a partial area of a back surface of the silicon wafer substrate, and the area B is an area of the back surface of the silicon wafer substrate that does not belong to the area A;
the first treatment comprises performing the texturing process on the area A of the front surface of the silicon wafer substrate with a chemical liquid for texturing, and performing an etching process on the area A of the back surface of the silicon wafer substrate.

3. The method for preparing the solar cell according to claim 2, wherein forming the phosphorous-boron co-doped silicon oxide layer on the area B comprises the following steps of:
forming a phosphorous-boron co-doped silicon oxide layer on the back surface of the silicon wafer substrate;
patterning the back surface of the silicon wafer substrate to remove a part of the phosphorous-boron co-doped silicon oxide layer, wherein an area of the back surface of the silicon wafer substrate corresponding to a remaining phosphorus-boron co-doped silicon oxide layer is the area B.

4. The method for preparing the solar cell according to claim 3, wherein forming the phosphorous-boron co-doped silicon oxide layer on the back surface of the silicon wafer substrate comprises the following steps of:
forming a phosphorus-doped amorphous silicon film layer and a boron-doped silicon oxide layer sequentially on the back surface of the silicon wafer substrate; and
annealing the silicon wafer substrate, such that the phosphorus-doped amorphous silicon film layer is converted into a phosphorus-doped polycrystalline silicon film layer, and the boron-doped silicon oxide layer absorbs phosphorus elements to form the phosphorus-boron co-doped silicon oxide layer.

5. The method for preparing the solar cell according to claim 4, wherein the phosphorus-doped amorphous silicon film layer and the boron-doped silicon oxide layer are sequentially formed on the back surface of the silicon wafer substrate through plasma enhanced chemical vapor deposition.

6. The method for preparing the solar cell according to claim 4 or 5, wherein forming the phosphorus-doped amorphous silicon film layer comprises the following step of:
depositing the phosphorus-doped amorphous silicon film layer on the back surface of the silicon wafer substrate through plasma enhanced chemical vapor deposition by using a reaction gas containing phosphorane and silane, wherein during depositing the phosphorus-doped amorphous silicon film layer, a flow rate of the phosphorane in the reaction gas gradually increases.

7. The method for preparing the solar cell according to any one of claims 4 to 6, wherein forming the boron-doped silicon oxide layer comprises the following step of:
depositing the boron-doped silicon oxide layer on the back surface of the silicon wafer substrate by plasma enhanced chemical vapor deposition by using a reaction gas containing a boron source and silane, wherein during depositing the boron-doped silicon oxide layer, a flow rate of the boron source in the reaction gas to lower than 1/3 of a flow rate of the silane.

8. The method for preparing the solar cell according to any one of claims 4 to 7, wherein an annealing temperature is 800°C to 950°C, and an annealing time is 15 min to 60 min.

9. The method for preparing the solar cell according to claim 3, wherein forming the phosphorous-boron co-doped silicon oxide layer on the back surface of the silicon wafer substrate comprises the following steps of:
forming a phosphorus-doped silicon oxide layer on the back surface of the silicon wafer substrate through low-pressure chemical vapor deposition; and
performing boron diffusion on a surface of the phosphorus-doped silicon oxide layer to form the phosphorus-boron co-doped silicon oxide layer.

10. The method for preparing the solar cell according to any one of claims 3 to 9, wherein the patterning comprises the following step of:
treating the back surface of the silicon wafer substrate with a green laser or an ultraviolet laser to remove the part of the phosphorous-boron co-doped silicon oxide layer.

11. The method for preparing the solar cell according to any one of claims 4 to 8, wherein prior to forming the phosphorus-doped amorphous silicon film layer on the back surface of the silicon wafer substrate, the method further comprises the following step of:
forming an ultra-thin silicon oxide layer on the back surface of the silicon wafer substrate through plasma enhanced chemical vapor deposition, wherein the ultra-thin silicon oxide layer has a thickness from 1 nm to 3 nm.

12. The method for preparing the solar cell according to any one of claims 2 to 11, wherein after performing the first treatment on the area A, the method further comprises the following steps of:
removing the phosphorous-boron co-doped silicon oxide layer on the area B with a solution containing hydrogen fluoride; and
manufacturing a first electrode on the area A of the back surface of the silicon wafer substrate, and manufacturing a second electrode on the area B of the back surface of the silicon wafer substrate.

13. The method for preparing the solar cell according to claim 12, wherein after removing the phosphorous-boron co-doped silicon oxide layer on the area B and prior to manufacturing the first electrode and the second electrode, the method further comprises a step of depositing a first aluminum oxide film layer and a second aluminum oxide film layer on the front surface and the back surface of the silicon wafer substrate, respectively.

14. The method for preparing the solar cell according to claim 13, wherein after depositing the first aluminum oxide film layer and the second aluminum oxide film layer and prior to manufacturing the first electrode and the second electrode, the method further comprises a step of depositing a first anti-reflection film layer and a second anti-reflection film layer on the first aluminum oxide film layer and the second aluminum oxide film layer, respectively.

15. The method for preparing the solar cell according to claim 1, wherein the solar cell substrate is a silicon wafer substrate with a wrap-around layer on a front surface thereof, the area A comprises the front surface of the silicon wafer substrate, the area B comprises a back surface of the silicon wafer substrate; and the first treatment is the wrap-around removal process on the area A.

16. The method for preparing the solar cell according to claim 15, wherein forming the phosphorous-boron co-doped silicon oxide layer on the area B comprises the following steps of:
forming a phosphorus-doped amorphous silicon film layer and a boron-doped silicon oxide layer sequentially on the back surface of the silicon wafer substrate; and
annealing the silicon wafer substrate, such that the phosphorus-doped amorphous silicon film layer is converted into a phosphorus-doped polycrystalline silicon film layer, and the boron-doped silicon oxide layer absorbs phosphorus elements to form the phosphorus-boron co-doped silicon oxide layer.

17. The method for preparing the solar cell according to claim 16, wherein the phosphorus-doped amorphous silicon film layer and the boron-doped silicon oxide layer are sequentially formed on the back surface of the silicon wafer substrate through plasma enhanced chemical vapor deposition.

18. The method for preparing the solar cell according to claim 16 or 17, wherein forming the phosphorus-doped amorphous silicon film layer comprises the following step of:
depositing the phosphorus-doped amorphous silicon film layer on the back surface of the silicon wafer substrate through plasma enhanced chemical vapor deposition by using a reaction gas containing phosphorane and silane, wherein during depositing the phosphorus-doped amorphous silicon film layer, a flow rate of the phosphorane in the reaction gas gradually increases.

19. The method for preparing the solar cell according to any one of claims 16 to 18, wherein forming the boron-doped silicon oxide layer comprises the following step of:
depositing the boron-doped silicon oxide layer on the back surface of the silicon wafer substrate by plasma enhanced chemical vapor deposition by using a reaction gas containing a boron source and silane, wherein during depositing the boron-doped silicon oxide layer, a flow rate of the boron source in the reaction gas to lower than 1/3 of a flow rate of the silane during depositing the boron-doped silicon oxide layer.

20. The method for preparing the solar cell according to any one of claims 16 to 19, wherein an annealing temperature is 800°C to 950°C, and an annealing time is 15 min to 60 min.

21. The method for preparing the solar cell according to claim 15, wherein forming the phosphorous-boron co-doped silicon oxide layer on the area B comprises the following steps of:
forming a phosphorus-doped silicon oxide layer on the back surface of the silicon wafer substrate through low-pressure chemical vapor deposition; and
performing boron diffusion on a surface of the phosphorus-doped silicon oxide layer to form the phosphorus-boron co-doped silicon oxide layer.

22. A solar cell prepared by the method according to any one of claims 1 to 14.

23. The solar cell according to claim 22, wherein the solar cell comprises a silicon wafer substrate, an ultra-thin silicon oxide layer, a phosphorus-doped polycrystalline silicon film layer, a first electrode, and a second electrode;
the silicon wafer substrate has an n-type doped area and a p-type area on a back surface thereof, the ultra-thin silicon oxide layer and the phosphorus-doped polycrystalline silicon film layer are successively disposed within the n-type doped area of the back surface of the silicon wafer substrate, the first electrode is disposed within the p-type area and is in contact with the silicon wafer substrate; and the second electrode is disposed within the n-type doped area and is in contact with the phosphorus-doped polycrystalline silicon film layer.

24. The solar cell according to claim 23, wherein the solar cell further comprises a first aluminum oxide film layer, a first anti-reflection film layer, a second aluminum oxide film layer, and a second anti-reflection film layer;
the first aluminum oxide film layer and the first anti-reflection film layer are sequentially stacked on the front surface of the silicon wafer substrate; the second aluminum oxide film layer is disposed on a surface of the phosphorus-doped polycrystalline silicon film layer within the n-type doped area away from the ultra-thin silicon oxide layer and a surface of the silicon wafer substrate within the p-type area; the second anti-reflection film layer is disposed on a surface of the second aluminum oxide film layer away from the silicon wafer substrate; the first electrode extends through the second anti-reflection film layer and the second aluminum oxide film layer and is in contact with the silicon wafer substrate; and the second electrode extends through the second anti-reflection film layer and the second aluminum oxide film layer and is in contact with the phosphorus-doped polycrystalline silicon film layer.
